(19) Europäisches Patentamt

European Patent Office

Office européen des brevets

(11) **EP 4 600 738 A2**

(12) **EUROPEAN PATENT APPLICATION**

(43) Date of publication:
**13.08.2025 Bulletin 2025/33**

(21) Application number: **25184990.7**

(22) Date of filing: **24.06.2025**

(51) International Patent Classification (IPC):
*G03F 7/00* *(2006.01)*

(52) Cooperative Patent Classification (CPC):
**G03F 7/706**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(71) Applicant: **ASML Netherlands B.V.
5500 AH Veldhoven (NL)**

(72) Inventor: **GEELEN, Paul, Jean, Maurice
5500 AH Veldhoven (NL)**

(74) Representative: **ASML Netherlands B.V.
Corporate Intellectual Property
P.O. Box 324
5500 AH Veldhoven (NL)**

(54) **WAVEFRONT ABERRATION MEASUREMENT SYSTEM AND EXPOSURE APPARATUS**

(57)    A wavefront aberration measurement system for determining aberrations of a projection system is described, the system comprising:

a first 2 dimensional grating, a second 2 dimensional grating, a radiation source configured to irradiate the first 2 dimensional grating, and a detector configured to detect radiation from the radiation source having in sequence interacted with the first 2 dimensional grating, the projection system and the second 2 dimensional grating and

The system further comprises a control device configured to perform phase stepping by moving the first 2 dimensional grating and the second 2 dimensional grating in respect of each other along a diagonal of the first 2 dimensional grating and the second 2 dimensional grating with an alignment phase difference between the X-direction and the Y-direction, thereby obtaining detector data.

GR1XY, GR2

Fig. 8D

Y

DIA

X

EP 4 600 738 A2

**Description**

FIELD

The present invention relates to a wavefront aberration measurement system, an exposure apparatus comprising said wavefront aberration measurement system, and a method of determining aberrations of a projection system of an exposure apparatus.

BACKGROUND

In semiconductor device manufacturing processes, apparatuses can be used to process and/or assess objects such as a substrate or a patterning device. An example of such an apparatus is an exposure apparatus used to generate interactions between a radiation, for example an electromagnetic radiation or a charged-particle radiation, with a substrate. Other examples of such apparatuses are a deposition apparatus, an etching apparatus, and a die-bonding apparatus. A lithographic apparatus and an assessment apparatus are examples of an exposure apparatus. A lithographic apparatus may use an electromagnetic radiation or a charged-particle radiation to form a pattern onto a layer of radiation-sensitive material, for example a layer of photo resist, provided on a substrate. Examples of a lithographic apparatus are a deep ultraviolet (DUV) lithographic apparatus and an extreme ultraviolet (EUV) lithographic apparatus. An assessment apparatus may form interaction products resulting from interaction of an electromagnetic radiation or charged-particle radiation with an object such as a substrate or a patterning device. An inspection apparatus and a metrology apparatus are examples of such assessment apparatuses and may be used to detect particles or measure a critical dimension, for example.

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

A lithographic apparatus, or any other exposure apparatus comprises a projection system which is configured to project a pattern from an object plane onto an imaging plane. A wavefront shearing interferometer may be used to determine aberrations of the projection system. A first 2 dimensional grating is arranged at the object plane and a second 2 dimensional grating is arranged at the image plane. A detector detects radiation successively having interacted with the first 2 dimensional grating, projected by the projection system onto the second 2 dimensional grating, and having interacted with the second 2 dimensional grating. The measurements involve a phase stepping whereby the first 2 dimensional grating and the second 2 dimensional grating are phase stepped in respect of each other. The phase stepping may be performed in X direction using an X-grating at the object plane and at the image plane, and is performed in Y direction using an Y-grating at the object plane and at the image plane. Interference patterns are determined to arrive at phase maps from which the aberrations may be determined.

The determination of the aberrations may be relatively time-consuming, which may affect an effective throughput of the exposure apparatus.

SUMMARY

It is desirable to enhance a throughput of the exposure apparatus.

According to an aspect, there is provided a wavefront aberration measurement system for determining aberrations of a projection system, the wavefront aberration measurement system comprising:

a first 2 dimensional grating configured to be arranged in an object plane of the projection system,
a second 2 dimensional grating configured to be arranged in an image plane of the projection system,
a radiation source configured to irradiate the first 2 dimensional grating,
a detector configured to detect radiation originating from the radiation source which has in sequence interacted with the first 2 dimensional grating, the projection system and the second 2 dimensional grating,
wherein the exposure apparatus further comprises a control device configured to:

perform phase stepping by moving the first 2 dimensional grating and the second 2 dimensional grating in respect of each other along a diagonal of the first 2 dimensional grating and the second 2 dimensional grating with an alignment phase difference between the X-direction and the Y-direction, thereby obtaining detector data, modulate the detector data obtained during the phase stepping with a sine function and cosine function to separate the detector data for the X-direction and the Y-direction, and

determine the aberrations of the projection system using the separated detector data for the X-direction and the Y-direction.

According to an aspect, there is provided exposure apparatus comprising a projection system and the wavefront aberration measurement system according to any one of the preceding claims to determine the aberrations of the projection system.

According to an aspect, there is provided a method of determining aberrations of a projection system of an exposure apparatus by means of phase stepping using a wavefront shearing interferometer comprising a first 2 dimensional grating, a second 2 dimensional grating and a detector, the method comprising:

irradiating a radiation beam onto the first 2 dimensional grating to interact with the first 2 dimensional grating in an object plane of the projection system;

projecting by the projection system the radiation beam having interacted with the first 2 dimensional grating onto the second 2 dimensional grating to interact with the second 2 dimensional grating in an image plane of the projection system;

detecting by the detector the radiation beam having interacted with the second 2 dimensional grating;

performing phase stepping by moving the first 2 dimensional grating and the second 2 dimensional grating in respect of each other along a diagonal of the first 2 dimensional grating and the second 2 dimensional grating with an alignment phase difference between the X-direction and the Y-direction, thereby obtaining detector data;

modulating the detector data obtained during the phase stepping with a sine function and cosine function to separate the detector data for the X-direction and the Y-direction, and

determining the aberrations of the projection system using the separated detector data for the X-direction and the Y-direction.

BRIEF DESCRIPTION OF THE DRAWINGS

Embodiments of the invention will now be described, by way of example only, with reference to the accompanying schematic drawings, in which:

- Figure 1 depicts a lithographic system comprising a lithographic apparatus and a radiation source;
- Figure 2 depicts a schematic illustration of a measurement system according to an embodiment of the invention;
- Figures 3A and 3B are schematic illustrations of a patterning device and a sensor apparatus which may form part of the measurement system of Figure 2;
- Figure 4 is a schematic illustration of a measurement system according to an embodiment of the invention, the measurement system comprising a first patterned region and a second patterned region, the first patterned region arranged to receive

  radiation and to form a plurality of first diffraction beams;
- Figures 5A to 5C each shows a different set of second diffraction beams formed by the second patterned region of the measurement system shown in Figure 4, that set of second diffraction beams having been produced by a different first diffraction beam formed by the first patterned region;
- Figure 6A and 6B depict examples of object plane gratings in X direction respectively in Y direction;
- Figure 7A - 7C depict an image plane grating and overlays of the object plane gratings on the image plane gratings;
- Figure 8A and 8B depict a 2 dimensional object plane grating and a 2 dimensional image plane grating;
- Figures 8C - 8G depict overlays of the object plane gratings on the image plane gratings, based on which a phase stepping will be explained;
- Figures 9A - 9C depict sine and cosine functions based on which a demodulation will be explained.

DETAILED DESCRIPTION

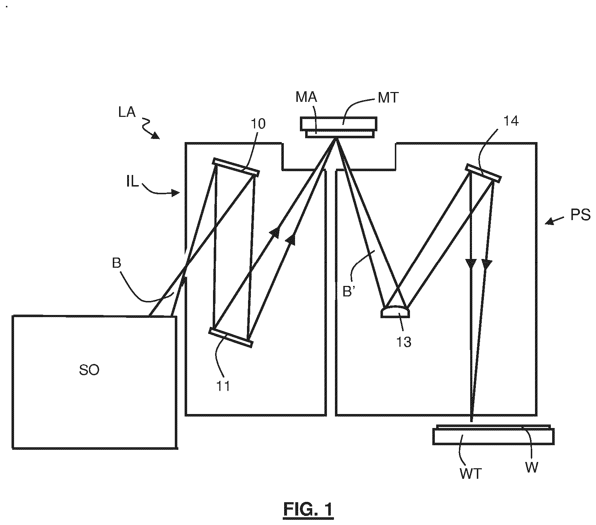

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

In general, the projection system PS has an optical transfer function which may be nonuniform, which can affect the pattern which is imaged on the substrate W. For unpolarized radiation such effects can be fairly well described by two scalar maps, which describe the transmission (apodization) and relative phase (aberration) of radiation exiting the projection system PS as a function of position in a pupil plane thereof. These scalar maps, which may be referred to as the transmission map and the relative phase map, may be expressed as a linear combination of a complete set of basis functions. A particularly convenient set is the Zernike polynomials, which form a set of orthogonal polynomials defined on a unit circle. A determination of each scalar map may involve determining the coefficients in such an expansion. Since the Zernike polynomials are orthogonal on the unit circle, the Zernike coefficients may be obtained from a measured scalar map by calculating the inner product of the measured scalar map with each Zernike polynomial in turn and dividing this by the square of the norm of that Zernike polynomial. In the following, unless stated otherwise, any reference to Zernike coefficients will be understood to mean the Zernike coefficients of a relative phase map (also referred to herein as an aberration map). It will be appreciated that in alternative embodiments other sets of basis functions may be used. For example some embodiments may use Tatian Zernike polynomials, for example for obscured aperture systems.

The wavefront aberration map represents the distortions of the wavefront of light approaching a point in an image plane of the projection system PS from a spherical wavefront (as a function of position in the pupil plane or, alternatively, the angle at which radiation approaches the image plane of the projection system PS). As discussed, this wavefront aberration map $W(x, y)$ may be expressed as a linear combination of Zernike polynomials:

$$W(x, y) = \sum_n c_n \cdot Z_n(x, y) \tag{1}$$

where $x$ and $y$ are coordinates in the pupil plane, $Z_n(x, y)$ is the nth Zernike polynomial and $c_n$ is a coefficient. It will be appreciated that in the following, Zernike polynomials and coefficients are labelled with an index which is commonly referred to as a Noll index. Therefore, $Z_n(x, y)$ is the Zernike polynomial having a Noll index of n and $c_n$ is a coefficient having a Noll index of n. The wavefront aberration map may then be characterized by the set of coefficients $c_n$ in such an expansion, which may be referred to as Zernike coefficients.

It will be appreciated that only a finite number of Zernike orders are taken into account. Different Zernike coefficients of the phase map may provide information about different forms of aberration which are caused by the projection system PS. The Zernike coefficient having a Noll index of 1 may be referred to as the first Zernike coefficient, the Zernike coefficient having a Noll index of 2 may be referred to as the second Zernike coefficient and so on.

The first Zernike coefficient relates to a mean value (which may be referred to as a piston) of a measured wavefront. The first Zernike coefficient may be irrelevant to the performance of the projection system PS and as such may not be determined using the methods described herein. The second Zernike coefficient relates to the tilt of a measured wavefront in the x-direction. The tilt of a wavefront in the x-direction is equivalent to a placement in the x-direction. The third Zernike coefficient relates to the tilt of a measured wavefront in the y-direction. The tilt of a wavefront in the y-direction is equivalent to a placement in the y-direction. The fourth Zernike coefficient relates to a defocus of a measured wavefront. The fourth Zernike coefficient is equivalent to a placement in the z-direction. Higher order Zernike coefficients relate to other forms of aberration which are caused by the projection system (e.g. astigmatism, coma, spherical aberrations and other effects).

Throughout this description the term "aberrations" should be intended to include all forms of deviation of a wavefront from a perfect spherical wavefront. That is, the term "aberrations" may relate to the placement of an image (e.g. the second, third and fourth Zernike coefficients) and/or to higher order aberrations such as those which relate to Zernike coefficients having a Noll index of 5 or more. Furthermore, any reference to an aberration map for a projection system may include all forms of deviation of a wavefront from a perfect spherical wavefront, including those due to image placement.

The transmission map and the relative phase map are field and system dependent. That is, in general, each projection system PS will have a different Zernike expansion for each field point (i.e. for each spatial location in its image plane).

As will be described in further detail below, the relative phase of the projection system PS in its pupil plane may be determined by projecting radiation from an object plane of the projection system PS (i.e. the plane of the patterning device MA), through the projection system PS and using a shearing interferometer to measure a wavefront (i.e. a locus of points with the same phase). The shearing interferometer may comprise a diffraction grating, for example a two dimensional diffraction grating, in an image plane of the projection system (i.e. the substrate table WT) and a detector arranged to detect an interference pattern in a plane that is conjugate to a pupil plane of the projection system PS.

The projection system PS comprises a plurality of optical elements (including mirrors 13, 14). As already explained, although the projection system PS is illustrated as having only two mirrors 13, 14 in Figure 1, the projection system PS may include a different number of mirrors (e.g. six or eight mirrors). The lithographic apparatus LA further comprises adjusting means PA for adjusting these optical elements so as to correct for aberrations (any type of phase variation across the pupil plane throughout the field). To achieve this, the adjusting means PA may be operable to manipulate optical elements within the projection system PS in one or more different ways. The projection system may have a co-ordinate system wherein its optical axis extends in the z direction (it will be appreciated that the direction of this z axis changes along the optical path through the projection system, for example at each mirror or optical element). The adjusting means PA may be operable to do any combination of the following: displace one or more optical elements; tilt one or more optical elements; and/or deform one or more optical elements. Displacement of optical elements may be in any direction (x, y, z or a combination thereof). Tilting of optical elements is typically out of a plane perpendicular to the optical axis, by rotating about axes in the x or y directions although a rotation about the z axis may be used for non-rotationally symmetric optical elements. Deformation of an optical element may be performed for example by using actuators to exert force on sides of the optical element and/or by using heating elements to heat selected regions of the optical element. In general, it may not be possible to adjust the projection system PS to correct for apodizations (transmission variation across the pupil plane). The transmission map of a projection system PS may be used when designing masks MAs for the lithographic apparatus LA.

In some embodiments, the adjusting means PA may be operable to move the support structure MT and/or the substrate table WT. The adjusting means PA may be operable to displace (in any of the x, y, z directions or a combination thereof) and/or tilt (by rotating about axes in the x or y directions) the support structure MT and/or the substrate table WT.

A projection system PS which forms part of a lithographic apparatus may periodically undergo a calibration process. For example, when a lithographic apparatus is manufactured in a factory the optical elements (e.g. mirrors) which form the projection system PS may be set up by performing an initial calibration process. After installation of a lithographic apparatus at a site at which the lithographic apparatus is to be used, the projection system PS may once again be calibrated. Further calibrations of the projection system PS may be performed at regular intervals. For example, under normal use the projections system PS may be calibrated every few months (e.g. every three months).

Calibrating a projection system PS may comprise passing radiation through the projection system PS and measuring the resultant projected radiation. Measurements of the projected radiation may be used to determine aberrations in the projected radiation which are caused by the projection system PS. Aberrations which are caused by the projection system PS may be determined using a measurement system. In response to the determined aberrations, the optical elements which form the projection system PS may be adjusted so as to correct for the aberrations which are caused by the projection system PS.

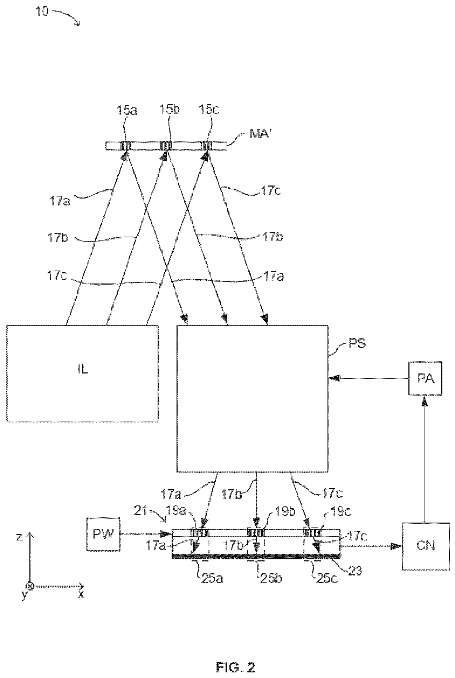

Figure 2 is a schematic illustration of a measurement system 10 which may be used to determine aberrations which are caused by a projection system PS. The measurement system 10 comprises an illumination system IL, a measurement patterning device MA', a sensor apparatus 21 and a controller CN. The measurement system 10 may form part of a lithographic apparatus. For example, the illumination system IL and the projection system PS which are shown in Figure 2 may be the illumination system IL and projection system PS of the lithographic apparatus which is shown in Figure 1. For ease of illustration additional components of a lithographic apparatus are not shown in Figure 2.

The measurement patterning device MA' is arranged to receive radiation from the illumination system IL. The sensor apparatus 21 is arranged to receive radiation from the projection system PS. During normal use of a lithographic apparatus, the measurement patterning device MA' and the sensor apparatus 21 which are shown in Figure 2 may be located in positions that are different to the positions in which they are shown in Figure 2. For example, during normal use of a lithographic apparatus a patterning device MA which is configured to form a pattern to be transferred to a substrate W may be positioned to receive radiation from the illumination system IL and a substrate W may be positioned to receive radiation from the projection system PS (as is shown, for example, in Figure 1). The measurement patterning device MA' and the sensor apparatus 21 may be moved into the positions in which they are shown in Figure 2 in order to determine aberrations which are caused by the projection system PS. The measurement patterning device MA' may be supported by a support structure MT, such as the support structure which is shown in Figure 1. The sensor apparatus 21 may be supported by a substrate table, such as the substrate table WT which is shown in Figure 1. Alternatively the sensor apparatus 21 may be supported by a measurement table (not shown) which may be separate to the sensor table WT.

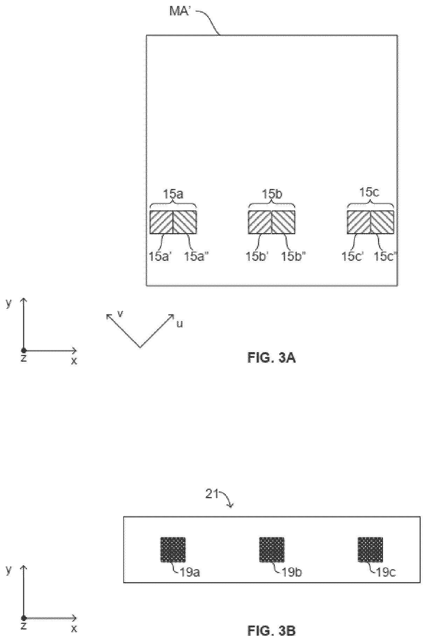

The measurement patterning device MA' and the sensor apparatus 21 are shown in more detail in Figures 3A and 3B. Cartesian co-ordinates are used consistently in Figures 2, 3A and 3B. Figure 3A is a schematic illustration of the measurement patterning device MA' in an x-y plane and Figure 3B is a schematic illustration of the sensor apparatus 21 in an x-y plane.

The measurement patterning device MA' comprises a plurality of patterned regions 15a-15c. In the embodiment which is shown in Figures 2 and 3A the measurement patterning device MA' is a reflective patterning device MA'. The patterned regions 15a-15c each comprises a reflective diffraction grating. Radiation which is incident on the patterned regions 15a-15c of the measurement patterning device MA' is at least partially scattered by thereby and received by the projection system PS. In contrast, radiation which is incident on the remainder of the measurement patterning device MA' is not reflected or scattered towards the projection system PS (for example, it may be absorbed by the measurement patterning device MA').

The illumination system IL illuminates the measurement patterning device MA' with radiation. Whilst not shown in Figure 2, the illumination system IL may receive radiation from a radiation source SO and condition the radiation so as to illuminate the measurement patterning device MA'. For example, the illumination system IL may condition the radiation so as to provide radiation having a desired spatial and angular distribution. In the embodiment which is shown in Figure 2, the illumination system IL is configured to form separate measurement beams 17a-17c. Each measurement beam 17a-17c illuminates a respective patterned region 15a-15c of the measurement patterning device MA'.

In order to perform a determination of aberrations which are caused by the projection system PL, a mode of the illumination system IL may be changed in order to illuminate the measurement patterning device MA' with separate measurement beams 17a-17c. For example, during normal operation of a lithographic apparatus, the illumination system IL may be configured to illuminate a patterning device MA with a slit of radiation. However the mode of the illumination system IL may be changed such that the illumination system IL is configured to form separate measurement beams 17a-17c in order to perform a determination of aberrations caused by the projection system PL. In some embodiments different patterned regions 15a-15c may be illuminated at different times. For example, a first subset of the patterned regions 15a-15c may be illuminated at a first time so as to form a first subset of measurement beams 17a-17c and a second subset of patterned regions 15a-15c may be illuminated at a second time so as to form a second subset of measurement beams 17a-17c.

In other embodiments the mode of the illumination system IL may be unchanged in order to perform a determination of aberrations caused by the projection system PL. For example, the illumination system IL may be configured to illuminate the measurement patterning device MA' with a slit of radiation (e.g. which substantially corresponds with an illumination area used during exposure of substrates). Separate measurement beams 17a-17c may then be formed by the measurement patterning device MA' since only the patterned regions 15a-15c reflect or scatter radiation towards the projection system PS.

In the Figures the Cartesian co-ordinate system is shown as being conserved through the projection system PS. However, in some embodiments the properties of the projection system PS may lead to a transformation of the co-ordinate system. For example, the projection system PS may form an image of the measurement patterning device MA' which is magnified, rotated and/or mirrored relative to the measurement patterning device MA'. In some embodiments the projection system PS may rotate an image of the measurement patterning device MA' by approximately 180° around the z-axis. In such an embodiment the relative positions of a first measurement beam 17a and a third measurement beam 17c which are shown in Figure 2, may be swapped. In other embodiments the image may be mirrored about an axis which may lie in an x-y plane. For example, the image may be mirrored about the x-axis or about the y-axis.

In embodiments in which the projection system PS rotates an image of the measurement patterning device MA' and/or the image is mirrored by the projection system PS, the projection system is considered to transform the co-ordinate system. That is, the co-ordinate system which is referred to herein is defined relative to an image which is projected by the projection system PS and any rotation and/or mirroring of the image causes a corresponding rotation and/or mirroring of the co-ordinate system. For ease of illustration, the co-ordinate system is shown in the Figures as being conserved by the projection system PS. However, in some embodiments the co-ordinate system may be transformed by the projection system PS.

The patterned regions 15a-15c modify the measurement beams 17a-17c. In particular, the patterned regions 15a-15c cause a spatial modulation of the measurement beams 17a-17c and cause diffraction in the measurement beams 17a-17c. In the embodiment which is shown in Figure 3B the patterned regions 15a-15c each comprise two distinct portions. For example, a first patterned region 15a comprises a first portion 15a' and a second portion 15a". The first portion 15a' comprises a diffraction grating which is aligned parallel to a u-direction and the second portion 15a" comprises a diffraction grating which is aligned parallel to a v-direction. The u and v-directions are depicted in Figure 3A. The u and v-directions are both aligned at approximately 45° relative to both the x and y-directions and are aligned perpendicular to each other. Second 15b and third 15c patterned regions which are shown in Figure 3A are identical to the first patterned region 15a and each comprise first and second portions whose diffraction gratings are aligned perpendicular to each other.

The first and second portions of the patterned regions 15a-15c may be illuminated with the measurement beams 17a-17c at different times. For example, the first portions of each of the patterned regions 15a-15c may be illuminated by the measurement beams 17a-17c at a first time. At a second time the second portions of each of the patterned regions 15a-15c may be illuminated by the measurement beams 17a-17c. As was mentioned above in some embodiments different patterned regions 15a-15c may be illuminated at different times. For example, the first portions of a first subset of patterned regions 15a-15c may be illuminated at a first time and the first portions of a second subset of patterned regions 15a-15c may be illuminated at a second time. Second portions of the first and second subsets of patterned regions may be illuminated at the same or different times. In general any schedule of illuminating different portions of patterned regions 15a-15c may be used.

The modified measurement beams 17a-17c are received by the projection system PS. The projection system PS forms an image of the patterned regions 15a-15c on the sensor apparatus 21. The sensor apparatus 21 comprises a plurality of diffraction gratings 19a-19c and a radiation detector 23. The diffraction gratings 19a-19c are arranged such that each diffraction grating 19a-19c receives a respective modified measurement beam 17a-17c which is output from the projection system PL. The modified measurement beams 17a-17c which are incident on the diffraction gratings 19a-19c are further modified by the diffraction gratings 19a-19c. The modified measurement beams which are transmitted at the diffraction gratings 19a-19c are incident on the radiation detector 23.

The radiation detector 23 is configured to detect the spatial intensity profile of radiation which is incident on the radiation detector 23. The radiation detector 23 may, for example, comprise an array of individual detector elements or sensing elements. For example, the radiation detector 23 may comprise an active pixel sensor such as, for example, a CMOS (complementary metal-oxide-semiconductor) sensor array. Alternatively, the radiation detector 23 may comprise a CCD (charge-coupled device) sensor array. The diffraction gratings 19a-19c and portions of the radiation sensor 23 at which the modified measurement beams 17a-17c are received form detector regions 25a-25c. For example, a first diffraction grating 19a and a first portion of the radiation sensor 23 at which a first measurement beam 17a is received together form a first detector region 25a. A measurement of a given measurement beam 17a-17c may be made at a respective detector region 25a-25c (as depicted). As was described above, in some embodiments the relative positioning of the modified measurement beams 17a-17c and the co-ordinate system may be transformed by the projection system PS.

The modification of the measurement beams 17a-17c which occurs at the patterned regions 15a-15c and the diffraction gratings 19a-19c of the detector regions 25a-25c results in interference patterns being formed on the radiation detector 23. The interference patterns are related to the derivative of the phase of the measurement beams and depend on aberrations caused by the projection system PS. The interference patterns may therefore be used to determine aberrations which are caused by the projection system PS.

In general, the diffraction gratings 19a-19c of each of the detector regions 25a-25c comprises a two-dimensional transmissive diffraction grating. In the embodiment which is shown in Figure 3B the detector regions 25a-25c each comprise a diffraction grating 19a-19c which is configured in the form of a checkerboard. As described further below, embodiments of the present invention have particular application to arrangements where the detector regions 25a-25c each comprises a two-dimensional transmissive diffraction grating 19a-19c that is not configured in the form of a checkerboard.

Illumination of the first portions of the patterned regions 15a-15c may provide information related to aberrations in a first direction and illumination of the second portions of the patterned regions 15a-15c may provide information related to aberrations in a second direction.

In some embodiments, the measurement patterning device MA' and/or the sensor apparatus 21 is sequentially scanned and/or stepped in two perpendicular directions. For example, the measurement patterning device MA' and/or the sensor apparatus 21 may be stepped relative to each other in the u and v-directions. The measurement patterning device MA' and/or the sensor apparatus 21 may be stepped in the u-direction whilst the second portions 15a"-15c" of the patterned regions 15a-15c are illuminated and the measurement patterning device MA' and/or the sensor apparatus 21 may be stepped in the v-direction whilst the first portions 15a'-15c' of the patterned regions 15a-15c are illuminated. That is, the measurement patterning device MA' and/or the sensor apparatus 21 may be stepped in a direction which is perpendicular to the alignment of a diffraction grating which is being illuminated.

The measurement patterning device MA' and/or the sensor apparatus 21 may be stepped by distances which correspond with a fraction of the grating period of the diffraction gratings. Measurements which are made at different stepping positions may be analysed in order to derive information about a wavefront in the stepping direction. For example, the phase of the first harmonic of the measured signal (which may be referred to as a phase stepping signal) may contain information about the derivative of a wavefront in the stepping direction. Stepping the measurement patterning device MA' and/or the sensor apparatus 21 in both the u and v-directions (which are perpendicular to each other) therefore allows information about a wavefront to be derived in two perpendicular directions (in particular, it provides information about a derivative of the wavefront in each of the two perpendicular directions), thereby allowing the full wavefront to be reconstructed.

In addition to stepping of the measurement patterning device MA' and/or the sensor apparatus 21 in a direction which is perpendicular to the alignment of a diffraction grating which is being illuminated (as was described above), the measurement patterning device MA' and/or the sensor apparatus 21 may also be scanned relative to each other. Scanning of the measurement patterning device MA' and/or the sensor apparatus 21 may be performed in a direction which is parallel to the alignment of a diffraction grating which is being illuminated. For example, the measurement patterning device MA' and/or the sensor apparatus 21 may be scanned in the u-direction whilst the first portions 15a'-15c' of the patterned regions 15a-15c are illuminated and the measurement patterning device MA' and/or the sensor apparatus 21 may be scanned in the v-direction whilst the second portions 15a"-15c" of the patterned regions 15a-15c are illuminated. Scanning of the measurement patterning device MA' and/or the sensor apparatus 21 in a direction which is parallel to the alignment of a diffraction grating which is being illuminated allows measurements to be averaged out across the diffraction grating, thereby accounting for any variations in the diffraction grating in the scanning direction. Scanning of the measurement patterning device MA' and/or the sensor apparatus 21 may be performed at a different time to the stepping of the measurement patterning device MA' and/or the sensor apparatus 21 which was described above.

It will be appreciated that a variety of different arrangements of the patterned regions 15a-15c and the detector regions 25a-25c may be used in order to determine aberrations caused by the projection system PS. The patterned regions 15a-15c and/or the detector regions 25a-25c may comprise diffraction gratings. In some embodiments the patterned regions 15a-15c and/or the detector regions 25a-25c may comprise components other than a diffraction grating. For example, in some embodiments the patterned regions 15a-15c and/or the detector regions may comprise a single slit or a pin-hole opening through which at least a portion of a measurement beam 17a-17c may propagate. In general the patterned regions and/or the detector regions may comprise any arrangement which serves to modify the measurement beams.

The controller CN receives measurements made at the sensor apparatus 21 and determines, from the measurements, aberrations which are caused by the projection system PS. The controller may be configured to control one or more components of the measurement system 10. For example, the controller CN may control a positioning apparatus PW which is operable to move the sensor apparatus 21 and/or the measurement patterning device MA' relative to each other. The controller may control an adjusting means PA for adjusting components of the projection system PS. For example, the adjusting means PA may adjust optical elements of the projection system PS so as to correct for aberrations which are caused by the projection system PS and which are determined by the controller CN.

In some embodiments, the controller CN may be operable to control the adjusting means PA for adjusting the support structure MT and/or the substrate table WT. For example, the adjusting means PA may adjust support structure MT and/or substrate table WT so as to correct for aberrations which are caused by placement errors of patterning device MA and/or substrate W (and which are determined by the controller CN).

Determining aberrations (which may be caused by the projection system PS or by placement errors of the patterning device MA or the substrate W) may comprise fitting the measurements which are made by the sensor apparatus 21 to Zernike polynomials in order to obtain Zernike coefficients. Different Zernike coefficients may provide information about different forms of aberration which are caused by the projection system PS. Zernike coefficients may be determined independently at different positions in the x and/or the y-directions. For example, in the embodiment which is shown in Figure 2, 3A and 3B, Zernike coefficients may be determined for each measurement beam 17a-17c.

In some embodiments the measurement patterning device MA' may comprise more than three patterned regions, the sensor apparatus 21 may comprise more than three detector regions and more than three measurement beams may be formed. This may allow the Zernike coefficients to be determined at more positions. In some embodiments the patterned regions and the detector regions may be distributed at different positions in both the x and y-directions. This may allow the Zernike coefficients to be determined at positions which are separated in both the x and the y-directions.

Whilst, in the embodiment which is shown in Figures 2, 3A and 3B the measurement patterning device MA' comprises three patterned regions 15a-15c and the sensor apparatus 21 comprises three detector regions 25a-25c, in other embodiments the measurement patterning device MA' may comprise more or less than three patterned regions 15a-15c and/or the sensor apparatus 21 may comprise more or less than three detector regions 25a-25c.

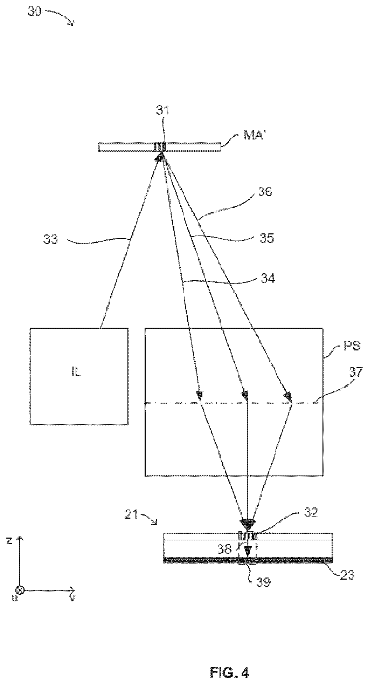

Methods for determining aberrations caused by a projection system PS are now described with reference to Figure 4.

In general, measurement patterning device MA' comprises at least one first patterned region 15a-15c and the sensor apparatus 21 comprises at least one second patterned region 19a-19c.

Figure 4 is a schematic illustration of a measurement system 30 which may be used to determine aberrations which are caused by a projection system PS. Measurement system 30 may be the same as the measurement system 10 shown in Figure 2, however, it may have a different number of first patterned regions (on measurement patterning device MA') and second patterned regions (in the sensor apparatus 21). Therefore, the measurement system 30 shown in Figure 4 may include any features of the measurement system 10 shown in Figure 2 described above and these features will not be further described below.

In Figure 4, only a single first patterned region 31 is provided on the measurement patterning device MA' and a single second patterned region 32 is provided in the sensor apparatus 21.

The measurement patterning device MA' is irradiated with radiation 33 from the illumination system IL. For ease of understanding only a single line (which may, for example, represent a single ray, for example the chief ray, of an incident radiation beam) is shown in Figure 4. However, it will be appreciated that the radiation 33 will comprise a range of angles incident on the first patterned region 31 of the measurement patterning device MA'. That is, each point on the first patterned region 31 of the measurement patterning device MA' may be illuminated by a cone of light. In general, each point is illuminated by substantially the same range of angles, this being characterized by the intensity of radiation in a pupil plane of the illumination system IL (not shown).

The first patterned region 31 is arranged to receive the radiation 33 and to form a plurality of first diffraction beams 34, 35, 36. A central first diffraction beam 35 corresponds to a $0^{th}$ order diffraction beam of first patterned region 31 and the other two first diffraction beams 34, 36 correspond to the $\pm 1^{st}$ order diffraction beams of first patterned region 31. It will be appreciated that more, higher order diffraction beams will, in general, also be present. Again for ease of understanding, only three first diffraction beams 34, 35, 36 are shown in Figure 4.

It will also be appreciated that, as the incoming radiation 33 comprises a cone of radiation converging on a point on the first patterned region 31, each of the first diffraction beams 34, 35, 36 also comprises a cone of radiation diverging from that point on the first patterned region 31.

To achieve the generation of the first diffraction beams 34, 35, 36, the first patterned region 31 may be of the form of a diffraction grating. For example, the first patterned region 31 may be generally of the form of the patterned region 15a shown in Figure 3A. In particular, at least a portion of the first patterned region 31 may be of the form of the first portion 15a' of the patterned region 15a shown in Figure 3A, i.e. a diffraction grating which is aligned parallel to a u-direction (note that Figure 4 is shown in the z-v plane). Therefore, the first diffraction beams 34-36 are separated in a shearing direction, which is the v-direction.

The first diffraction beams 34-36 are at least partially captured by the projection system PS, as now described. How much of the first diffraction beams 34-36 is captured by the projection system PS will be dependent on: the pupil fill of the incident radiation 33 from the illumination system IL; the angular separation of the first diffraction beams 34-36 (which in turn is dependent on the pitch of the first patterned region 31 and the wavelength of the radiation 33); and the numerical aperture of the projection system PS.

The measurement system 30 may be arranged such that first diffraction beam 35 that corresponds to the $0^{th}$ order diffraction beam substantially fills the numerical aperture of the projection system PS, which may be represented by a circular region of a pupil plane 37 of the projection system PS, and the first diffraction beams 34, 36 that correspond to the $\pm 1^{st}$ order diffraction beams overlap significantly with the first diffraction beam 35 that corresponds to the $0^{th}$ order diffraction beam. With such an arrangement, substantially all of the first diffraction beam 35 that corresponds to the $0^{th}$ order diffraction beam and most of the first diffraction beams 34, 36 that correspond to the $\pm 1^{st}$ order diffraction beams is captured by the projection system PS and projected onto the sensor apparatus 21. (Furthermore, with such an arrangement a large number of diffraction beams generated by the first patterned region 31 are at least partially projected onto the sensor apparatus 21).

The role of the first patterned region 31 is to introduce spatial coherence, as now discussed.

In general, two rays of radiation 33 from the illumination system IL that are incident on the same point of the measurement patterning device MA' at different angles of incidence are not coherent. By receiving the radiation 33 and forming a plurality of first diffraction beams 34, 35, 36, the first patterned region 31 may be considered to form a plurality of copies of the incident radiation cone 33 (the copies having, in general different phases and intensities). Within any one of these copies, or first diffraction beams 34, 35, 36, two rays of radiation which originate from the same point on the measurement patterning device MA' but at different scattering angles, are not coherent (due to the properties of the illumination system IL). However, for a given ray of radiation within any one of the first diffraction beams 34, 35, 36 there is a corresponding ray of radiation in each of the other first diffraction beams 34, 35, 36 that is spatially coherent with that given ray. For example, the chief rays of each of the first diffraction beams 34, 35, 36 (which correspond to the chief ray of the incident radiation 33) are coherent and could, if combined, interfere at the amplitude level.

This coherence is exploited by the measurement system 30 to determine an aberration map of the projection system PS.

The projection system PS projects part of the first diffraction beams 34, 35, 36 (which is captured by the numerical aperture of the projection system) onto the sensor apparatus 21.

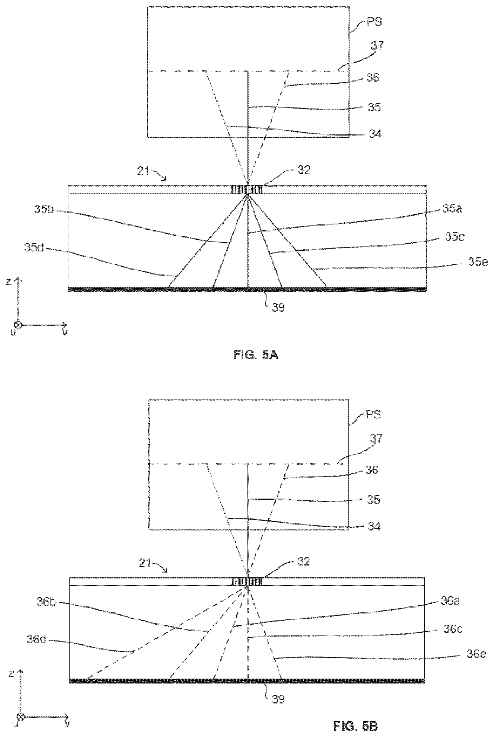

In Figure 4, the sensor apparatus 21 comprises the single second patterning region 32. As described further below (with reference to Figures 5A-5C), second patterned region 32 is arranged to receive these first diffraction beams 34-36 from the projection system PS and to form a plurality of second diffraction beams from each of the first diffraction beams. In order to achieve this, the second patterning region 32 comprises a two-dimensional transmissive diffraction grating. In Figure 4, all radiation that is transmitted by the second patterning region 32 is represented as a single arrow 38. This radiation 38 is received by a detector region 39 of the radiation detector 23 and is used to determine the aberration map.

Each of the first diffraction beams 34-36 that is incident on the patterning region 32 will diffract to from a plurality of second diffraction beams. Since the second patterning region 32 comprises a two-dimensional diffraction grating, from each incident first diffraction beam, a two dimensional array of secondary diffraction beams is produced (the chief rays of these secondary diffraction beams being separated in both the shearing direction (v-direction) and the direction perpendicular thereto (the u-direction). In the following, a diffraction order that is $n^{th}$ order in the shearing direction (the v-direction) and $m^{th}$ order in the non-shearing direction (the u-direction) will be referred to as the $(n, m)^{th}$ diffraction order of the second patterned region 32. In the following, where it is not important what order a second diffraction beam is in the non-shearing direction (the u-direction), the $(n, m)^{th}$ diffraction order of the second patterned region 32 may be referred to simply as the $n^{th}$ order second diffraction beam.

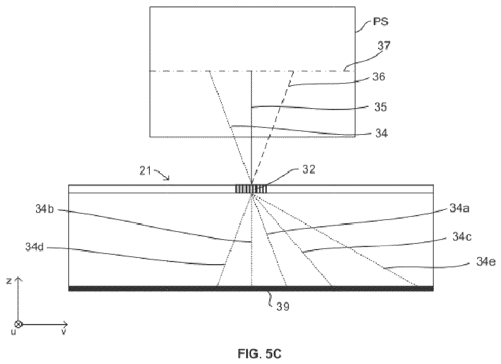

Figures 5A to 5C show a set of second diffraction beams produced by each of the first diffraction beams 34-36. Figure 5A shows a set of second diffraction beams 35a-35e produced by the first diffraction beam 35 that corresponds to the $0^{th}$ order diffraction beam of first patterned region 31. Figure 5B shows a set of second diffraction beams 36a-36e produced by the first diffraction beam 36 that corresponds to the $-1^{st}$ order diffraction beam of first patterned region 31. Figure 5C shows a set of second diffraction beams 34a-34e produced by the first diffraction beam 34 that corresponds to the $+1^{st}$ order diffraction beam of first patterned region 31.

In Figure 5A, second diffraction beam 35a corresponds to the $0^{th}$ order diffraction beam (of second patterned region 32, and in the shearing direction), whereas second diffraction beams 35b, 35c correspond to the $\pm 1^{st}$ order diffraction beams and second diffraction beams 35d, 35e correspond to the $\pm 2^{nd}$ order diffraction beams. It will be appreciated that Figures 5A-5C are shown in the v-z plane and the shown second diffraction beams may, for example, correspond to $0^{th}$ order diffraction beam of second patterned region 32 in the non-shearing direction (i.e. the u-direction). It will be further appreciated that there will be a plurality of copies of these second diffraction beams, representing higher order diffraction beams in the non-shearing direction that are into or out of the page of Figures 5A-5C.

In Figure 5B, second diffraction beam 36a corresponds to the $0^{th}$ order diffraction beam (of second patterned region 32, and in the shearing direction), whereas second diffraction beams 36b, 36c correspond to the $\pm 1^{st}$ order diffraction beams and second diffraction beams 36d, 36e correspond to the $\pm 2^{nd}$ order diffraction beams.

In Figure 5C, second diffraction beam 34a corresponds to the $0^{th}$ order diffraction beam (of second patterned region 32, and in the shearing direction), whereas second diffraction beams 34b, 34c correspond to the $\pm 1^{st}$ order diffraction beams and second diffraction beams 34d, 34e correspond to the $\pm 2^{nd}$ order diffraction beams.

It can be seen from Figures 5A-5C that several of the second diffraction beams spatially overlap with each other. For example, the second diffraction beam 35b that corresponds to the $-1^{st}$ order diffraction beam of second patterned region 32, which originates from the $0^{th}$ order diffraction beam 35 of first patterned region 31 overlaps with the second diffraction beam 36a that corresponds to the $0^{th}$ order diffraction beam of second patterned region 32, which originates from the $-1^{st}$ order diffraction beam 36 of first patterned region 31. All of the lines in Figures 4 and 5A-5C may be considered to represent a single ray of radiation that originates from a single input ray 33 from the illumination system IL. Therefore, as explained above, these lines represent spatially coherent rays that, if spatially overlapping at radiation detector 23 will produce an interference pattern. Furthermore, the interference is between rays which have passed though different parts of the pupil plane 37 of the projection system PS (which are separated in the shearing direction). Therefore, the interference of radiation that originates from a single input ray 33 is dependent on phase differences between two different parts of the pupil plane.

This spatial overlapping and spatial coherence of the second diffraction beams at radiation detector 23 is achieved by matching the first and second patterned regions 31, 32 such that the angular separation (in the shearing direction) between different second diffraction beams that originate from a given first diffraction beam is the same as the angular separation (in the shearing direction) between different first diffraction beams as they converge on the second patterned region 32. This spatial overlapping and spatial coherence of the second diffraction beams at radiation detector 23 is achieved by matching the pitches of the first and second patterned regions 31, 32 in the shearing direction. It will be appreciated that this matching of the pitches of the first and second patterned regions 31, 32 in the shearing direction takes into account any reduction factor applied by the projection system PS. As used herein, the pitch of a two dimensional diffraction grating in a particular direction is defined as follows.

It will be appreciated that a one-dimensional diffraction grating comprises a series of lines that are formed from a repeating pattern (of reflectivity or transmissivity) in a direction perpendicular to these lines. In the direction perpendicular to the lines, the smallest non-repeating section from which the repeating pattern is formed is referred to as the unit cell and the length of this unit cell is referred to as the pitch of the one-dimensional diffraction grating. In general, such a one-dimensional diffraction grating will have a diffraction pattern such that an incident radiation beam will be diffracted so as to form a one-dimensional array of angularly spaced (but potentially spatially overlapping) diffraction beams. The first patterned region 31 forms such a one-dimensional array of angularly spaced first diffraction beams 34-36, which are offset (angularly spaced) in the shearing direction.

It will be appreciated that a two-dimensional diffraction grating comprises a two-dimensional repeating pattern of reflectivity or transmissivity. The smallest non-repeating section from which this repeating pattern is formed may be referred to as the unit cell. The unit cell may be square and a fundamental pitch of such a two-dimensional diffraction grating may be defined as a length of the square unit cell. In general, such a two dimensional diffraction grating will have a diffraction pattern such that an incident radiation beam will be diffracted so as to form a two dimensional array of, angularly spaced (but potentially spatially overlapping) diffraction beams. The axes of this two-dimensional (square) array of diffraction beams are parallel to the sides of the unit cell. The angular separation between adjacent diffraction beams in these two directions may be given by the ratio of the wavelength of the radiation to the pitch of the grating. Therefore, the smaller the pitch, the larger the angular separation between the adjacent diffraction beams.

Taking any reduction (or enlargement) factor applied by the projection system PS into account, either the pitch of the second patterned region 32 in the shearing direction should be an integer multiple of the pitch of the first patterned region 31 in the shearing direction or the pitch of the first patterned region 31 in the shearing direction should be an integer multiple of the pitch of the second patterned region 32 in the shearing direction. In the example shown in Figures 5A-5C, the pitches of the first and second patterned regions 31, 32 in the shearing direction are substantially equal (taking into account any reduction factor).

As can be seen from Figures 5A-5C, each point on the detector region 39 of the radiation detector 23 will, in general, receive several contributions that are summed coherently. For example, the point on the detector region 39 which receives the second diffraction beam 35b that corresponds to the $-1^{st}$ order diffraction beam of second patterned region 32, which originates from the $0^{th}$ order diffraction beam 35 of first patterned region 31 overlaps with both: (a) the second diffraction beam 36a that corresponds to the $0^{th}$ order diffraction beam of second patterned region 32, which originates from the $-1^{st}$ order diffraction beam 36 of first patterned region 31; and (b) the second diffraction beam 34d that corresponds to the $-2^{nd}$ order diffraction beam of second patterned region 32, which originates from the $+1^{st}$ order diffraction beam 34 of first patterned region 31. It will be appreciated that when higher order diffraction beams of the first patterned region 31 are taken into account there will be more beams that should be summed coherently at each point on the detector region 39 in order to determine the intensity of radiation as measured by that part of the detector region 39 (for example a corresponding pixel in a two dimensional array of sensing elements).

In general, a plurality of different second diffraction beams contributes to the radiation received by each part of the detector region 39. The intensity of radiation from such a coherent sum is given by:

$$(2)$$

$$I = DC + \sum_{\text{pairs}\,\{i\}} \gamma_i \cos(\Delta\phi_i),$$

where $DC$ is a constant term (which is equivalent to the incoherent sum of the different diffraction beams), the sum is over all pairs of different second diffraction beams, $\gamma_i$ is an interference strength for that pair of second diffraction beams and $\Delta\Phi_i$ is a phase difference between that pair of second diffraction beams.

The phase difference $\Delta\Phi_i$ between a pair of second diffraction beams is dependent on two contributions: (a) a first contribution relates to the different part of the pupil plane 37 of the projection system PS from which they originate; and (b) a second contribution relates to the position within the unit cells of each of the first and second patterned regions 31, 32 from which they originate.

The first of these contributions can be understood to arise from the fact that the different coherent radiation beams have passed through different parts of the projection system PS and are therefore related to the aberrations that it is desired to determine (in fact they are related to a difference between two points in the aberration map that are separated in the shearing direction).

The second of these contributions can be understood to arise from the fact that the relative phases of multiple rays of radiation that arise from a single ray incident on a diffraction grating will depend on which part of the unit cell of that grating the ray was incident. This therefore does not contain information relating to the aberrations. As explained above, in some embodiments, the measurement patterning device MA' and/or the sensor apparatus 21 are sequentially scanned and/or stepped in the shearing direction. This causes the phase differences between all of pairs of interfering radiation beams received by the radiation detector 23 to change. As the measurement patterning device MA' and/or the sensor apparatus 21 are sequentially stepped in the shearing direction by an amount that is equivalent to a fraction of the pitches (in the shearing direction) of the first and second patterned regions 31, 32, in general, the phase differences between pairs of second diffraction beams will all change. If the measurement patterning device MA' and/or the sensor apparatus 21 are stepped in the shearing direction by an amount that is equivalent to an integer multiple of the pitches (in the shearing direction) of the first and second patterned regions 31, 32 the phase differences between pairs of second diffraction beams will remain the same. Therefore, as the measurement patterning device MA' and/or the sensor apparatus 21 are by sequentially scanned and/or stepped in the shearing direction, the intensity received by each part of the radiation detector 23 will oscillate. The first harmonic of this oscillating signal (which may be referred to as a phase-stepping signal), as measured by the radiation detector 23, is dependent on the contributions to equation (1) that arise from adjacent first diffraction beams 34-36, i.e. first diffraction beams that differ in order by $\pm 1$. Contributions that arise from first diffraction beams that differ in order by a different amount will contribute to higher order harmonics of the signal determined by the radiation detector 23 due to such phase stepping techniques.

For example, of the three overlapping second diffraction beams discussed above (35b, 36a and 34d) only two of the three possible pairs of these diffraction beams will contribute to the first harmonic of the phase stepping signal: (a) second diffraction beams 35b and 36a (which originate from the $0^{th}$ order diffraction beam 35 and the $-1^{st}$ order diffraction beam 36 of first patterned region 31 respectively); and (b) second diffraction beams 35a and 34d (which originate from the $0^{th}$ order diffraction beam 35 and the $+1^{st}$ order diffraction beam 34 of first patterned region 31 respectively).

Each pair of second diffraction beams will result in an interference term of the form shown in equation (2), which contributes to the first harmonic of the phase stepping signal, i.e. an interference term of the form:

$$(3)$$

$$\gamma \cos(\frac{2\pi}{p} \cdot v + \Delta W)$$

where y is an amplitude of the interference term, $p$ is the pitch of the first and second patterned regions 31, 32 (in the shearing direction), v parameterizes the relative positions of the first and second patterned regions 31, 32 in the shearing direction and $\Delta W$ is a difference between the value of the aberration map at two positions in the pupil plane of the projection system PS, the two positions corresponding to the positions from which the two second diffraction beams originate. The amplitude y of the interference term is proportional to the product of the compound scattering efficiencies of the two second diffraction beams, as discussed further below. The frequency of the first harmonic of the phase stepping signal is given by the inverse of the pitch $p$ of the first and second patterned regions 31, 32 in the shearing direction. The phase of the phase stepping signal is given by $\Delta W$ (the difference between the values of the aberration map at two positions in the pupil plane of the projection system PS, the two positions corresponding to the positions from which the two second diffraction beams originate).

The interference strength $\gamma_i$ for a pair of second diffraction beams is proportional to the product of the compound scattering efficiencies of the two second diffraction beams, as now discussed.

In general, the scattering efficiency of the diffraction beams produced by a diffraction grating will depend on the geometry of the grating. These diffraction efficiencies, which may be normalised to the efficiency of a $0^{th}$ order diffraction beam, describe the relative intensities of the diffraction beams. As used herein, the compound scattering efficiency of a second diffraction beam is given by the product of the scattering efficiency of the first diffraction beam from which it originates and the scattering efficiency for the diffraction order of the second patterned region 32 to which it corresponds.

In the above description of the embodiments shown in Figures 3A to 5C, where the first portion 15a' of the patterned region 15a shown in Figure 3A is illuminated, the shearing direction corresponds to the v-direction and the non-shearing direction corresponds to the u-direction. It will be appreciated that when the second portion 15a" of the patterned region 15a shown in Figure 3A is illuminated, the shearing direction corresponds to the u-direction and the non-shearing direction corresponds to the v-direction. Although in these above-described embodiments, the u and v-directions (which define the two shearing directions) are both aligned at approximately 45° relative to both the x and y-directions of the lithographic apparatus LA, it will be appreciated that in alternative embodiments the two shearing directions may be arranged at any angle to the x and y-directions of the lithographic apparatus LA (which may correspond to non-scanning and scanning directions of the lithographic apparatus LA). In general, the two shearing directions will be perpendicular to each other. In the following, the two shearing directions will be referred to as the x-direction and the y-direction. However, it will be appreciated that these shearing directions may be arranged at any angle relative to both the x and y-directions of the lithographic apparatus LA.

The phase stepping requires a relatively large number of steps to be performed, in order to accurately determine the aberrations from the measurements. A phase stepping in x-direction may involve plural steps in x-direction, whereby measurements are performed with each step. A phase stepping in y-direction may involve plural steps in y-direction, whereby measurements are performed with each step. The phase stepping and measurements in x-direction are performed using a grating having a repetitive pattern along the x direction. The phase stepping and measurements in y-direction are performed using a grating having a repetitive pattern along the y direction. For example, plural tens of steps in x direction are performed and plural tens of steps in y direction are performed. The performing of a relatively large number of steps results in a relatively long overall measurement time in order to obtain a sequence of measurements from which the aberration may be determined.

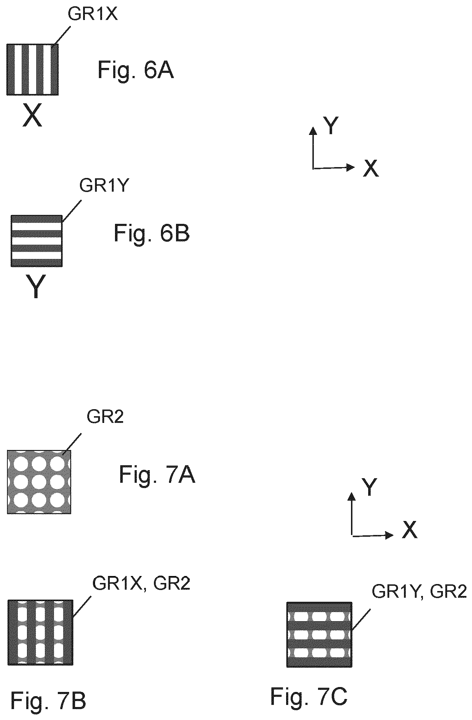

Figure 6A depicts a schematic view of a one dimensional grating GR1X, as may be employed with the phase stepping in the x-direction. Similarly, Figure 6B depicts a schematic view of a one dimensional grating GR1Y, as may be employed with the phase stepping in the y-direction. The one dimensional grating for the x-direction comprises a repetitive grating pattern along the x-direction, while the one dimensional grating for the y-direction comprises a repetitive grating pattern along the y-direction. The gratings with the patterns as depicted in Figures 6A and 6B may be arranged at the object plane, and may be projected by the projection system onto a grating at the image plane.

An example of the grating at the image plane is depicted in Figure 7A. According to the depicted embodiment, the grating GR2 at the image plane comprises a two dimensional grating, i.e. the grating comprises a grating pattern that repeats both in the x-direction as well as in the y-direction. As a result, the same grating at the image plane may be employed with the phase stepping in the x-direction as well as with the phase stepping in the y-direction. For example, as depicted in Figure 7A, the grating at the image plane comprises a plurality of pinholes arranged along the x-direction and the y-direction to form a 2 dimensional arrangement. Although the grating in Figure 6A and 6B on the one hand and the grating in Figure 7A on the other hand are depicted at substantially a same scale, it is noted that the gratings may be scaled in size according to an optical image magnification factor of the projection system.

Figure 7B depicts an imaging of the X-directional, one dimensional grating GR1X according to Figure 6A via the projection system onto the image plane grating GR2 as depicted in Figure 7A. In the relative position as depicted in Figure 7B, the gratings are substantially in phase, i.e. the transmissive lines of the object plane grating according to Figure 6A are aligned in the x direction with the holes of the image plane grating according to Figure 7A. With the phase stepping along the x-direction, the gratings will move relative to each other along the x direction.

Figure 7C depicts an imaging of the Y-directional, one dimensional grating GR1Y according to Figure 6B via the projection system onto the image plane grating GR2 as depicted in Figure 7A. In the relative position as depicted in Figure 7C, the gratings are substantially in phase, i.e. the transmissive lines of the object plane grating according to Figure 6B are aligned in the y-direction with the holes of the image plane grating according to Figure 7B. With the phase stepping along the y-direction, the gratings will move relative to each other along the y direction.

As described above, the beams diffracted by the object plane grating may be projected by the projection system onto the image plane grating, where they are diffracted by the image plane grating and interact with each other on the detector. A resulting intensity pattern on the detector is measured. With the phase stepping along the x-direction, the object plane grating (Fig. 6A) and the image plane grating (Fig. 7A) move in phase relative to each other with the phase stepping in the x direction, causing the intensity pattern on the detector to change. The aberration in the x direction may be derived from the thus obtained detector data.

Similarly, with the phase stepping along the y-direction, the object plane grating (Fig. 6B) and the image plane grating (Fig. 7A) move in phase relative to each other with the phase stepping in the y direction, causing the intensity pattern on the detector to change. The aberration in the y direction may be derived from the thus obtained detector data.

As mentioned above, it is desirable to enhance a throughput of the exposure apparatus. In order to enhance a throughput of the exposure apparatus, it is desirable to reduce a time involved with the determination of the aberrations of the projection system.

According to an aspect, there is provided a wavefront aberration measurement system for determining aberrations of a projection system, the wavefront aberration measurement system comprising:

a first 2 dimensional grating configured to be arranged in an object plane of the projection system,
a second 2 dimensional grating configured to be arranged in an image plane of the projection system,
a radiation source configured to irradiate the first 2 dimensional grating,
a detector configured to detect radiation originating from the radiation source which has in sequence interacted with the first 2 dimensional grating, the projection system and the second 2 dimensional grating,
wherein the exposure apparatus further comprises a control device configured to:

perform phase stepping by moving the first 2 dimensional grating and the second 2 dimensional grating in respect of each other along a diagonal of the first 2 dimensional grating and the second 2 dimensional grating with an alignment phase difference between the X-direction and the Y-direction, thereby obtaining detector data,
modulate the detector data obtained during the phase stepping with a sine function and cosine function to separate the detector data for the X-direction and the Y-direction, and
determine the aberrations of the projection system using the separated detector data for the X-direction and the Y-direction.

The inventors have devised to perform the phase stepping using 2 dimensional gratings both at the object plane as well as at the image plane. The 2 dimensional gratings are to be understood as gratings which have a repetitive pattern in 2 dimensions, e.g. in the x-direction as well as in the y-direction. With the 2 dimensional gratings, a phase stepping is performed whereby the 2 dimensional gratings are moved in respect of each other along a diagonal of both of the gratings. The diagonal is to be understood as a direction diagonal in respect of the x-direction as well as in respect of the y-direction. The term diagonal may be defined as at an angle of 45 degrees. The movement along the direction diagonal in respect of the x-direction and in respect of the y-direction may provide for a phase stepping of the gratings at the object plane and at the image plane in respect of each other, the phase stepping both having a component along the x-direction as well as a component along the y-direction. The detector data of the detector may hence be affected both by the component of the phase stepping along the x-direction as well as by the component of the phase stepping along the y-direction.

The inventors have devised that the detector data as obtained with the phase stepping in the diagonal direction may be separated into detector data for the x-direction and the y-direction, in that, firstly, the phase stepping is performed with an alignment phase difference between the x-direction and the y-direction, and secondly, the detector data obtained during the phase stepping is modulated with a sine function and cosine function. By the alignment phase difference between the x-direction and the y-direction, the detector data for the x-direction and the y-direction may be separated in that the detector data is modulated with the sine function and the cosine function. The modulation with the sine function may enable to retrieve the detector data for one of the x-direction and the y-direction, and the modulation with the cosine function may enable to retrieve the detector data for the other one of the x-direction and the y-direction.

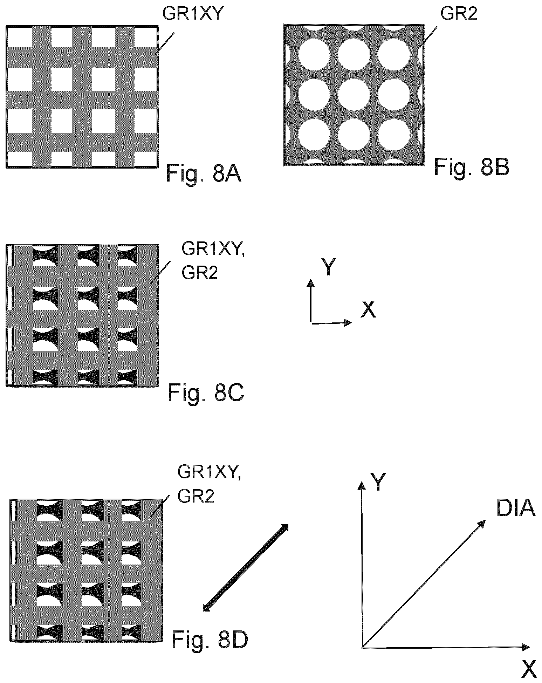

An example of the above phase stepping will be explained with reference to Figures 8A - 8D.

Figure 8A depicts a two dimensional grating GR1XY at object plane. The two dimensional grating comprises a grating pattern that is repetitive in two directions, e.g. in the x direction as well as in the y direction.

Figure 8B depicts an example of the two dimensional grating GR2 at the image plane. According to the depicted embodiment, the grating at the image plane comprises a two dimensional pattern of pinholes. Although the object plane grating in Figure 8A and the image plane grating in Figure 8B are depicted at substantially a same scale, it is noted that the gratings may be scaled in size according to the optical image magnification factor of the projection system.

Figure 8C depicts an optical overlay of the object plane grating GR1XY according to Figure 8A projected by the projection system onto the image plane grating GR2 according to Figure 8B. In the relative positions of the object plane and image plane gratings as depicted in Figure 8C, the gratings are in phase, i.e. aligned, seen in the X direction while the gratings are out of phase, i.e. with an alignment phase difference seen in the Y direction. Thus, the gratings are at an alignment phase difference between the x direction and the y direction.

Figure 8D schematically depicts a diagonal direction DIA, i.e. a direction at an angle of 45 degrees in respect of the X direction and in respect of the Y direction. A phase stepping is performed along the diagonal direction, i.e. the object plane grating and the image plane grating are phase stepped in respect of each other along the diagonal direction. One of the object plane and image plane gratings may be moved in the diagonal direction, or both may be moved to provide a relative movement in the diagonal direction. The phase stepping may provide a sequence of successive steps, each with a movement in the diagonal direction, whereby the successive steps result in an overall relative displacement of the object plane grating and the image plane grating relative to each other in the diagonal direction over one repetition period of the pattern. For example, in the case of 64 phase steps, the repetitive phase stepping may provide for an effective diagonal movement of the 64 phase steps combined with displace the image plane grating and the object plane grating relative to each other over one repetition period of the gratings in the X direction and one repetition period of the gratings in the Y direction. The repetition period of the gratings may be understood as a pitch of the gratings, i.e. a spatial repetition period of the gratings.

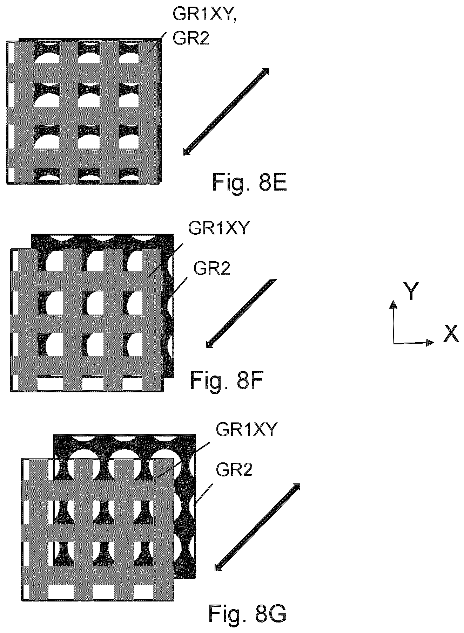

Figure 8E, 8F and 8G illustrate examples of some of the steps of the phase stepping, whereby with each step, the image plane grating GR1XY moves in the diagonal direction in respect of the object plane grating GR2. At the relative position of the image plane grating and the object plane grating as depicted in Figure 8E, the image plane grating and the object plane grating have moved relative to each other in the diagonal direction as compared to the relative positions in Figure 8D. At the relative position of the image plane grating and the object plane grating as depicted in Figure 8F, the image plane grating and the object plane grating have moved relative to each other in the diagonal direction as compared to the relative positions in Figure 8E. At the relative position of the image plane grating and the object plane grating as depicted in Figure 8G, the image plane grating and the object plane grating have moved relative to each other in the diagonal direction as compared to the relative positions in Figure 8E. Figures 8D, 8E, 8F and 8G depict a subset of the steps in the phase stepping, i.e. the phase stepping may involve plural steps between the relative positions of the object plane grating and the image plane grating according to Figures 8D and 8E, and similarly involve plural steps between the relative positions of the object plane grating and the image plane grating according to Figures 8E and 8F, as well as between Figures 8F and 8G.

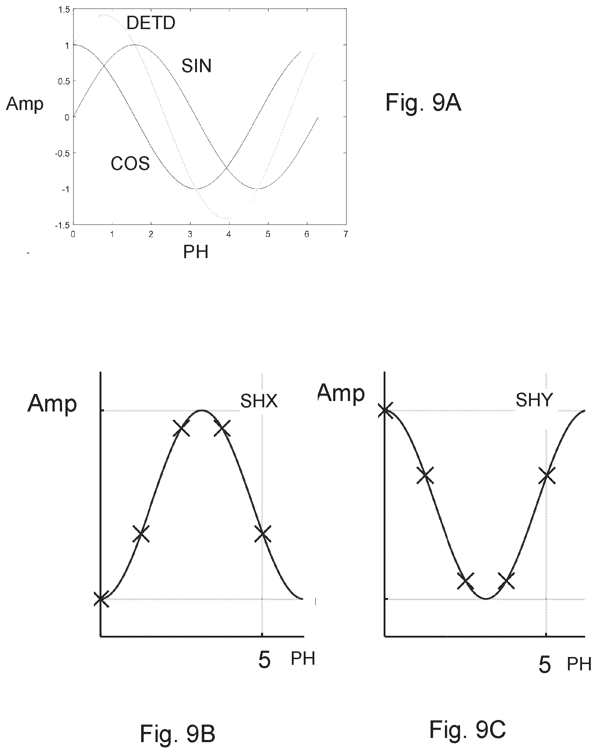

Figure 9A illustrates an amplitude of the detector signal as a function of the phase stepping of the object plane grating relative to the image plane grating. Phase stepping over one repetition period of the gratings is depicted, resulting in a phase from 0 to 2 pi radians, and a resulting detector signal having said periodicity of 2 pi radians.

The sequence of detector signals as obtained with the phase stepping is modulated by a sine function SIN and a cosine function COS. For example, the modulation by the sine function and the cosine function is performed per pixel of the detector data, i.e. the detector image data. For an exemplary pixel, a detector signal of the detector data is illustrated by detector data DETD in Figure 9A. Modulating the detector signal of the detector data by the sine function provides for the sine modulated component, and the modulation by the cosine function provides for the cosine modulated component. The phase difference between the x direction and the y direction may enable to separate the detector data in the x direction and the y direction by the sine and cosine modulation. Reverting to the phase stepping as depicted in Figures 8C - 8G, with the phase difference as depicted, the overlap of the openings in the grating in the x direction may be near its maximum in the relative position as depicted in Figure 8C and 8D, while the overlap of the openings in the grating in the y direction may be near its minimum in the same position. A shear SHX in X direction over a grating repetition period of 2 pi radians phase PH may be represented by Figure 9B, while a shear SHY in Y direction over the grating repetition period of 2 pi radians phase PH may be represented by Figure 9C.

A 2 dimensional grating is used at the object plane as well as at the image plane and a phase stepping is performed using said 2 dimensional gratings at the object and image planes. The phase stepping is further performed along a diagonal of the gratings rather than along the X- or Y-axis. As such, the phase stepping measurements will contain both data/information about the phase maps in X- and Y-direction. In order to separate both phase maps, the phase stepping is performed by applying a different aligning of the 2D reticle grating and the 2D wafer grating in the X-direction and the Y-direction. As a result of this alignment difference, the phase maps in X and Y can be separated by modulation of the data with a sin and cosine function.

As the 2 dimensional gratings are used to obtain the detector data for the X direction and for the Y direction, a deviation due to a height difference between the X grating (such as the object plane grating depicted in Figure 6A) and the Y grating (such as the object plane grating depicted in Figure 6B) may be avoided, which may enhance an accuracy of the aberration measurement.

A time involved with the phase stepping may be reduced, as the diagonal phase stepping may be performed in a shorter time compared to the combined times to perform the phase stepping with said X grating and the phase stepping with said Y grating.

The 2 dimensional grating at the object plane may be identified as a first 2 dimensional grating, and the 2 dimensional grating at the image plane may be identified as a second 2 dimensional grating.

In an embodiment, the alignment difference is 90 degrees or -90 degrees. The alignment difference of + or - 90 degrees may enable to achieve a highest extent of orthogonality between the detector data associated with the X direction and the Y direction, hence enabling a highly accurate separation into detector data for the X direction and detector data for the Y direction.

In an embodiment, the first 2 dimensional grating and the second 2 dimensional grating are aligned with the X-direction and the Y-direction, enabling to achieve an accurate separation of detector data for the X and Y directions.

In an embodiment, the control device is configured to perform the phase stepping along the diagonal of the X-direction and the Y-direction.

In an embodiment, the control device is configured to perform the phase stepping over one repetition period of the grating in X-direction and Y-direction. Plural steps of the phase stepping may be performed over said repetition period, e.g. 16, 32, 64 or 128 steps. An accurate determination of the aberrations may be performed.

In an embodiment, the periodic pattern of the first 2 dimensional grating and the second 2 dimensional grating along the X-direction and along the Y-directions are the same. A same pattern along the X direction and along the Y direction may facilitate the separation by the modulation with the sine and cosine functions.

In an embodiment, a periodicity of the periodic pattern of the first 2 dimensional grating and the second 2 dimensional grating along the X-direction and along the Y-directions is the same. With the same repetition period in the X direction and the Y direction, the sine and cosine functions may make use of a same repetition period, likewise facilitating the separation by the modulation with the sine and cosine functions.

In an embodiment, the first 2 dimensional grating comprises a Gingham pattern or a Checkerboard pattern.

In an embodiment, the second 2 dimensional grating comprises a pinhole pattern. In an alternative embodiment, the second 2 dimensional grating comprises a Gingham pattern or a Checkerboard pattern.

In an embodiment, the detector comprises a 2 dimensional detector array. The 2 dimensional detector array may enabling to detect an optical pattern of the radiation having interacted with the object plane grating and the image plane grating. The modulation with the sine function and the cosine function may be performed for each pixel of the 2 dimensional detector array.

In an embodiment, the control device is configured to associate the cosine function with the one of the X-direction and the Y-direction in which the gratings are aligned at phase zero and to associate the sine function with the other one of the X-direction and the Y-direction. With the phase stepping, at phase zero, the sine function may be zero while the cosine function may be one. The cosine may be associated with the one of the X-direction and the Y-direction in which the gratings are aligned at phase zero, i.e. due to the alignment, the gratings provide maximum amplitude in said direction, and the sine may be associated with the other one of the X-direction and the Y-direction in which the gratings are out of phase at phase zero, i.e. due to the alignment, the gratings provide minimum amplitude in said direction.

In an embodiment, the control device is configured to intermittently measure an amplitude of the sine function and cosine function and to use the intermittently measured amplitude of the sine function and cosine function to separate the detector data for the X-direction and the Y-direction. When modulating the detector data by the sine function and the cosine function, 3 variables may be unknown, namely the phases in the x and y directions, as well as the amplitude of the sine and cosine functions. The amplitude of the sine and cosine functions may change over time due to contamination and/or degradation. The amplitude of the sine and cosine functions may accordingly be relatively constant. An intermittent measurement, e.g. a periodic measurement once per day may assist to take account of gradual effects such as contamination.

In an embodiment, the control device is configured to determine Zernike polynomials from the phase stepping data of the 2 dimensional detector array modulated by the sine function and cosine function. The Zernike polynomials may describe aberrations such as tilt, defocus, etc. in an effective way.

According to a further aspect, there is provided an exposure apparatus comprising a projection system and the wavefront aberration measurement system according to the present invention to determine the aberrations of the projection system.

In an embodiment, the second grating is arranged on a substrate stage of the exposure apparatus. By arranging the second grating on the substrate stage of the exposure apparatus, aberrations of the projection system associated with the projection on the substrate may be determined, i.e. on an imaging plane of the pattern at the substrate. The detector of the wavefront aberration measurement system may also be arranged at the substrate.

In an embodiment, the first grating is arranged on a patterning device configured to be loaded into the exposure apparatus. The exposure apparatus may be configured to project a pattern from the patterning device onto a substrate. By arranging the first grating on the patterning device, aberrations of the projection system associated with the projection of the pattern from the patterning device may be determined, i.e. the aberration of the projection by the projection system from an optical plane substantially coinciding with the pattern of the patterning device when loaded into the exposure apparatus. Alternatively or in addition, the first grating may also be arranged on a fiducial which can e.g. be mounted to the support structure supporting or holding the patterning device, e.g. support structure MT as discussed above. Such a first grating provided on a fiducial may equally be positioned in an object plane of the projection system and thus assist in determining the aberrations of the projection system.

By arranging the second grating on the substrate stage of the exposure apparatus and the first grating on the patterning device, aberrations of the projection system associated with the projection of the pattern from the patterning device on the substrate may be determined, i.e. the aberration of the projection by the projection system from an optical plane substantially coinciding with the pattern of the patterning device when loaded into the exposure apparatus, to an imaging plane of the pattern at the substrate.

In an embodiment, the radiation source comprises an EUV or DUV radiation source of the exposure apparatus. Thus, the radiation source of the wavefront aberration measurement system may be the radiation source of the exposure apparatus. The radiation source of the exposure apparatus may comprise a DUV or EUV radiation source. The determination of aberrations of the projection system may thereby be performed using the radiation source of the exposure apparatus that is configured to generate the radiation beam to project the pattern from the patterning device onto the substrate. An accuracy of the determination of the aberrations may be enhanced, as the same radiation source, i.e. a same spectral content, a same spatial radiation distribution, etc. may be used in the aberration measurement as used in the projection of the pattern on the substrate.

According to a yet further aspect, there is provided a method of determining aberrations of a projection system of an exposure apparatus by means of phase stepping using a wavefront shearing interferometer comprising a first 2 dimensional grating, a second 2 dimensional grating and a detector, the method comprising:

irradiating a radiation beam onto the first 2 dimensional grating to interact with the first 2 dimensional grating in an object plane of the projection system;
projecting by the projection system the radiation beam having interacted with the first 2 dimensional grating onto the second 2 dimensional grating to interact with the second 2 dimensional grating in an image plane of the projection system;
detecting by the detector the radiation beam having interacted with the second 2 dimensional grating;
performing phase stepping by moving the first 2 dimensional grating and the second 2 dimensional grating in respect of each other along a diagonal of the first 2 dimensional grating and the second 2 dimensional grating with an alignment phase difference between the X-direction and the Y-direction, thereby obtaining detector data;
modulating the detector data obtained during the phase stepping with a sine function and cosine function to separate the detector data for the X-direction and the Y-direction, and
determining the aberrations of the projection system using the separated detector data for the X-direction and the Y-direction.

With the method, the same or similar effects may be achieved as described above with reference to the aberration measurement system. Likewise, the same or similar embodiments as described above with reference the aberration measurement system may be provided for the method.

The present development will be described in the below in a more mathematical way: The idea is to phase step with the object plane grating and the image plane grating in a diagonal way in respect of each other. The starting aligned position of the object plane and image plane gratings may be as follows: In one of the X and Y direction there is no phase difference of the gratings. In the other one of the X and Y direction there should be -90 degrees phase difference between the object plane and image plane gratings.

During diagonal stepping the pixel intensity at the detector may be then described with

$$I = Ox + Mx \cos(\varphi\_x + \theta\_x) + Oy + My \cos (\varphi\_y + \theta\_y)$$

$$I = Ox + Mx \cos(\varphi\_x + \theta\_x) + Oy + My \cos (\varphi\_y + \theta\_x - \pi/2)$$

$$I = Ox + Mx \cos(\varphi\_x + \theta\_x) + Oy + My \sin (\varphi\_y + \theta\_x)$$

with $\theta\_x$ the known, applied phase difference of the reticle and sensor grating and $\varphi$ the phase difference (gradient) of the interfering wavefronts

The measured pixel intensity contains modulating sin and cos function which are orthogonal.

The required $\varphi\_x$ and $\varphi\_y$ information may be obtained from the pixel intensity modulation. This may be done in the following way

Assume: Ox = Oy and Mx = My (this assumption may be accurate because the same grating is used), then

$$I = Ox + Mx \cos(\varphi\_x + \theta\_x) + Oy + My \sin (\varphi\_y + \theta\_x)$$

becomes:

$$I = 2Ox + Mx \cos(\varphi\_x + \theta\_x) + Mx \sin (\varphi\_y + \theta\_x) \qquad (1)$$

Using the following identity:

$$A \cos(wt + phi1) + B \sin(wt + phi2) = R \cos(wt + \Omega),$$

where

$$R \qquad = sqrt( A^2 + B^2 + 2AB \cos(phi1 - phi2) ) \ ,$$

and

$$\tan(\Omega) = (B \sin(phi2) + A \sin(phi1) ) / ( A \cos(phi1) + B \cos(phi2) )$$

equation (1) becomes:

$$I = 2Ox + R \cos(\theta\_x + \Omega) \ ,$$

with

$$R = sqrt( 2Mx^2 + 2Mx^2 \cos(\varphi\_x - \varphi\_y) )$$

and

$$\tan(\Omega) = (\sin(\varphi\_y) + \sin(\varphi\_x)) / (\cos(\varphi\_x) + \cos(\varphi\_y))$$

From the measured summed signal (for each pixel) the modulation term R and phase $\Omega$ can be extracted. In these 2 measured quantities R and $\Omega$ there are 3 unknows ($\varphi\_x$, $\varphi\_y$ *and* Mx). The unknowns $\varphi\_x$, $\varphi\_y$ are to be determined and therefore one may constrain the problem more by measuring periodically the Mx component. The Mx component may be measured by shearing not in the diagonal way but in a pure x or y direction. The Mx component may change due to grating contamination & degradation. Therefore it is recommended to measure the Mx component intermittently, e.g. once per day, per week, etc.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A wavefront aberration measurement system for determining aberrations of a projection system, the wavefront aberration measurement system comprising:

   - a first 2 dimensional grating configured to be arranged in an object plane of the projection system,
   - a second 2 dimensional grating configured to be arranged in an image plane of the projection system,
   - a radiation source configured to irradiate the first 2 dimensional grating,
   - a detector configured to detect radiation originating from the radiation source which has in sequence interacted with the first 2 dimensional grating, the projection system and the second 2 dimensional grating,
   wherein the exposure apparatus further comprises a control device configured to:

   perform phase stepping by moving the first 2 dimensional grating and the second 2 dimensional grating in respect of each other along a diagonal of the first 2 dimensional grating and the second 2 dimensional grating with an alignment phase difference between the X-direction and the Y-direction, thereby obtaining detector data,
   modulate the detector data obtained during the phase stepping with a sine function and cosine function to separate the detector data for the X-direction and the Y-direction, and
   determine the aberrations of the projection system using the separated detector data for the X-direction and the Y-direction.

2. The wavefront aberration measurement system according to claim 1, wherein the alignment difference is 90 degrees or -90 degrees.

3. The wavefront aberration measurement system according to claim 1 or 2, wherein the first 2 dimensional grating and the second 2 dimensional grating are aligned with the X-direction and the Y-direction.

4. The wavefront aberration measurement system according to any one of the preceding claims, wherein control device is configured to perform the phase stepping along the diagonal of the X-direction and the Y-direction.

5. The wavefront aberration measurement system according to any one of the preceding claims, wherein control device is configured to perform the phase stepping over one repetition period of the grating in X-direction and Y-direction.

6. The wavefront aberration measurement system according to any one of the preceding claims, wherein the periodic pattern of the first 2 dimensional grating and the second 2 dimensional grating along the X-direction and along the Y-directions are the same.

7. The wavefront aberration measurement system according to any one of the preceding claims, wherein a periodicity of the periodic pattern of the first 2 dimensional grating and the second 2 dimensional grating along the X-direction and along the Y-directions is the same.

8. The wavefront aberration measurement system according to any one of the preceding claims, wherein the first 2 dimensional grating comprises a Gingham pattern or a Checkerboard pattern.

9. The wavefront aberration measurement system according to any one of the preceding claims, wherein the second 2 dimensional grating comprises a pinhole pattern.

10. The wavefront aberration measurement system according to any one of the preceding claims, wherein the detector comprises a 2 dimensional detector array.

11. The wavefront aberration measurement system according to any one of the preceding claims, wherein control device is configured to associate the cosine function with the one of the X-direction and the Y-direction in which the gratings are aligned at phase zero and to associate the sine function with the other one of the X-direction and the Y-direction.

12. The wavefront aberration measurement system according to any one of the preceding claims, wherein the control device is configured to intermittently measure an amplitude of the sine function and cosine function and to use the intermittently measured amplitude of the sine function and cosine function to separate the detector data for the X-direction and the Y-direction.

13. The wavefront aberration measurement system according to any one of the preceding claims, wherein the control device is configured to determine Zernike polynomials from the phase stepping data of the 2 dimensional detector array modulated by the sine function and cosine function.

14. An exposure apparatus comprising a projection system and the wavefront aberration measurement system according to any one of the preceding claims to determine the aberrations of the projection system.

15. The exposure apparatus according to claim 14, wherein the second grating is arranged on a substrate stage of the exposure apparatus.

16. The exposure apparatus according to claim 14 or 15, wherein the first grating is arranged on a patterning device configured to be loaded into the exposure apparatus.

17. The exposure apparatus according to any one of claims 14 - 16, wherein the radiation source comprises an EUV or DUV radiation source of the exposure apparatus.

18. A method of determining aberrations of a projection system of an exposure apparatus by means of phase stepping using a wavefront shearing interferometer comprising a first 2 dimensional grating, a second 2 dimensional grating and a detector, the method comprising:

irradiating a radiation beam onto the first 2 dimensional grating to interact with the first 2 dimensional grating in an object plane of the projection system;

projecting by the projection system the radiation beam having interacted with the first 2 dimensional grating onto the second 2 dimensional grating to interact with the second 2 dimensional grating in an image plane of the projection system;

detecting by the detector the radiation beam having interacted with the second 2 dimensional grating;

performing phase stepping by moving the first 2 dimensional grating and the second 2 dimensional grating in respect of each other along a diagonal of the first 2 dimensional grating and the second 2 dimensional grating with an alignment phase difference between the X-direction and the Y-direction, thereby obtaining detector data;

modulating the detector data obtained during the phase stepping with a sine function and cosine function to separate the detector data for the X-direction and the Y-direction, and

determining the aberrations of the projection system using the separated detector data for the X-direction and the Y-direction.

**FIG. 1**

FIG. 2

MA'

15a    15b    15c

15a'  15a"    15b'  15b"    15c'  15c"

y

v    u

z    x

**FIG. 3A**

21

19a    19b    19c

y

z    x

**FIG. 3B**

FIG. 4

FIG. 5A

FIG. 5B

FIG. 5C

GR1X

Fig. 6A

X

GR1Y

Fig. 6B

Y

Y
X

GR2

Fig. 7A

Y
X

GR1X, GR2

Fig. 7B

GR1Y, GR2

Fig. 7C

GR1XY

Fig. 8A

GR2

Fig. 8B

GR1XY,
GR2

Fig. 8C

Y

X

GR1XY,
GR2

Fig. 8D

Y

DIA

X

GR1XY,
GR2

Fig. 8E

GR1XY

GR2

Fig. 8F

GR1XY

GR2

Fig. 8G

Y

X

Fig. 9A

Fig. 9B

Fig. 9C